# EUROPÄISCHE PATENTSCHRIFT

(11) **EP 2 251 879 B1**
(45) Veröffentlichungstag und Bekanntmachung des Hinweises auf die Patenterteilung: **24.06.2020**
(21) Anmeldenummer: 10161389.1
(22) Anmeldetag: 29.04.2010
(51) Int. Cl.: H01G 2/02, H01G 9/00, H05K 3/30

(54) **Verfahren zur Herstellung einer Anordnung mit einem Dämpfungselement für ein elektrisches oder elektronisches Bauteil**
Process for the production of an arrangement with an attenuation element for an electrical or electronic device
Procédé de fabrication d'un dispositif avec un amortissement pour un appareil électrique ou électronique

(30) Priorität: 13.05.2009 DE 102009003079
(43) Veröffentlichungstag der Anmeldung: 17.11.2010
(73) Patentinhaber: Robert Bosch GmbH, 70442 Stuttgart (DE)
(72) Erfinder: Weber, Matthias, 70825 Korntal-Muenchingen (DE); Geissler, Alexander, 07616 Buergel (DE)

(56) Entgegenhaltungen:
- WO-A1-01/78474
- WO-A1-2007/068663
- US-A- 4 872 937

## Beschreibung

### Stand der Technik

Die Erfindung betrifft ein Verfahren zur Herstellung einer Anordnung umfassend ein elektrisches oder elektronisches Bauteil nach dem Oberbegriff des Anspruchs 1.

Bei einem bekannten Dämpfungselement für einen Elektrolyt-Kondensator ist das Dämpfungselement als separater Halter ausgebildet, der einerseits mit dem Elektrolyt-Kondensator und andererseits zum Beispiel mit einer Leiterplatte verbunden ist. Das bekannte Dämpfungselement verursacht dadurch, dass es als separates Bauteil ausgebildet ist, zusätzliche Kosten. Weiterhin benötigt es zusätzlichen Bauraum.

Weiterhin ist es ebenfalls bei Elektrolyt-Kondensatoren bekannt, diese unter Zwischenlage eines Klebstoffes mit der Leiterplatte zu verbinden. Das Kleben ist jedoch ein zusätzlicher Prozessschritt, welcher dadurch einen zusätzlichen Aufwand erforderlich macht. Auch ist zu berücksichtigen, dass der Abstand zwischen dem Elektrolyt-Kondensator und der Leiterplatte, der die Vibrationsbeständigkeit des Elektrolyt-Kondensators beeinflusst, durch Fertigungstoleranzen bedingt schwanken kann. Durch die begrenzte Schichtdicke des Klebstoffes ist daher die Einhaltung der Fertigungstoleranzen wesentlich, um den Einsatz von Klebstoff als Dämpfungselement zu ermöglichen. Des Weiteren können die chemischen Inhaltsstoffe des Klebstoffes die Leiterplatte und den Elektrolyt-Kondensator angreifen, so dass es spezieller Klebstoffe bzw. Materialien bedarf.

Aus der JP 4307912 A und der JP 2007173693 sind jeweils Elektrolyt-Kondensatoren mit einem Dämpfungselement bekannt. Die bekannten Dämpfungselemente sind jedoch jeweils in dem Gehäuse der Kondensatoren angeordnet und dienen der Dämpfung von im Kondensatoren angeordneten Bauteilen und nicht der Dämpfung des Kondensators insgesamt in Bezug zu einem Schaltungsträger.

Aus Patentschrift US4872937 ist es bekannt, zwischen einem Bauteil und einem Schaltungsträger ein Dämpfungselement anzuordnen, welches sich aufgrund seiner Zusammensetzung (Foam) ausdehnen kann. Bei der Montage des Bauteils mit dem Schaltungsträger bzw. dem Dämpfungselement findet die Montage derart statt, dass das Bauteil unter direkter Zwischenlage des Dämpfungselements mit dem Schaltungsträger verbunden wird.

### Offenbarung der Erfindung

Die Erfindung hat es sich daher zur Aufgabe gestellt, ein Dämpfungselement für ein elektrisches oder elektronisches Bauteil in einem Verfahren nach dem Oberbegriff des Anspruchs 1 derart vorzusehen, dass das elektrisches oder elektronisches Bauteil unempfindlich gegenüber Fertigungstoleranzen ist, das Dämpfungselement universell einsetzbar ist, relativ geringe zusätzliche Kosten verursacht und eine höhere Vibrationsbeständigkeit des Bauteils ermöglicht. Diese Aufgabe wird in einem Verfahren unter Verwendung eines Dämpfungselements für ein elektrisches oder elektronisches Bauteil mit den Merkmalen des Anspruchs 1 gelöst. Der Erfindung liegt dabei die Grundidee zugrunde, ein Dämpfungselement zu verwenden, das sich erst unter dem Einfluss von Wärme und/oder chemischen Substanzen ausdehnt, und dann den Zwischenraum zwischen dem elektrischen bzw. elektronischen Bauteil und dem Schaltungsträger formschlüssig ausfüllt. Durch diese Ausbildung des Dämpfungselements kann das Dämpfungselement sich in hohem Maße an die örtlich gegebenen geometrischen Gegebenheiten des Bauteils und des Schaltungsträgers anpassen. Dadurch lässt sich zusätzlich auch ein Toleranzausgleich bewirken.

Vorteilhafte Weiterbildungen des erfindungsgemäß vorgesehenen Dämpfungselements für ein elektrisches oder elektronisches Bauteil sind in den Unteransprüchen angegeben. In den Rahmen der Erfindung fallen sämtliche Kombinationen aus zumindest zwei von in den Ansprüchen, der Beschreibung und/oder den Zeichnungen offenbarten Merkmalen.

In einer vorteilhaften Weiterbildung der Erfindung ist es vorgesehen, dass das Dämpfungselement als separates Element ausgebildet wird. Dadurch kann das elektrische bzw. elektronische Bauteil, ohne dieses in irgendeiner Form ändern zu müssen, unverändert übernommen werden.

Besonders vorteilhaft ist es dabei, wenn das Dämpfungselement an dem Bauteil auf der dem Schaltungsträger zugewandten Seite befestigt wird. Dadurch kann das Bauteil vor dem Montageprozess des Bauteils auf dem Schaltungsträger mit dem Dämpfungselement vorab montiert werden.

In einer alternativen Ausführungsform ist es jedoch auch möglich, das Dämpfungselement auf dem Schaltungsträger auf der dem Bauteil zugewandten Seite anzuordnen. In diesem Fall lässt sich die Montage des Dämpfungselements vorab vor der Bestückung der Leiterplatte mit dem elektrischen oder elektronischen Bauteil über einen Bestückungsautomaten ermöglichen.

Um sich zusätzliche Montagearbeiten des Dämpfungselements entweder am elektrischen oder elektronischen Bauteil oder an dem Schaltungsträger zu sparen, ist es in einer alternativen Ausführungsform vorgesehen, dass das Dämpfungselement als ein im Bauteil integriertes Element ausgebildet wird, das auf der dem Schaltungsträger zugewandten Seite im Bauteil angeordnet wird.

Besonders vorteilhaft bei dem Einsatz der erfindungsgemäß vorgesehenen Dämpfungselementes ist es, wenn die Aktivierung der Dämpfungselemente durch den Lötprozess erfolgt. Dadurch ist kein zusätzlicher Fertigungsprozessschritt erforderlich.

Um zu verhindern, dass es zu einer elektrischen Kontaktierung des Bauteils mit der Leiterplatte außerhalb der elektrischen Anschlüsse des Bauteils kommt, ist es darüber hinaus in einer vorteilhaften Weiterbildung vorgesehen, dass das Dämpfungselement aus einem elektrisch nicht leitenden Material besteht.

Ein derartiges Material, das gute Dämpfungseigenschaften aufweist und daher als Dämpfungselement einsetzbar ist, ist z. B. PU-Schaum.

Besonders vorteilhaft lässt sich das erfindungsgemäß vorgesehene Dämpfungselement bei Elektrolyt-Kondensatoren einsetzen. Dies deshalb, da diese Bauteile eine relativ hohe Masse besitzen und der Abstand zwischen der Leiterplatte und dem Bauteil relativ groß ist, sodass das Dämpfungselement sich einfach integrieren lässt.

Ein Schaltungsträger mit einem erfindungsgemäßen Dämpfungselement hat den Vorteil, dass dieser eine höhere Vibrationsbeständigkeit besitzt, so dass die Zuverlässigkeit des Schaltungsträgers steigt.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1: einen Elektrolyt-Kondensator mit Drahtanschlüssen, bei dem das Dämpfungselement als separates Bauteil ausgebildet ist, vor und nach dem Aktivieren des Dämpfungselements in einem Längsschnitt,
- Fig. 2: einen Elektrolyt-Kondensator in SMD-Bauweise, bei dem das Dämpfungselement als separates Bauteil ausgebildet ist, vor und nach der Aktivierung des Dämpfungselements in einem Längsschnitt,
- Fig. 3: einen Elektrolyt-Kondensator mit Drahtanschlüssen, bei dem das Dämpfungselement als integriertes Bauteil des Elektrolyt-Kondensators ausgebildet ist, vor und nach der Aktivierung des Dämpfungselements in einem Längsschnitt,
- Fig. 4: einen Elektrolyt-Kondensator in SMD-Bauweise, bei dem das Dämpfungselement als integriertes Bauteil ausgebildet ist, vor und nach der Aktivierung des Dämpfungselements im Längsschnitt und
- Fig. 5: einen Elektrolyt-Kondensator mit axial angeordneten Drahtanschlüssen mit einem Dämpfungselement, das auf einer Leiterplatte angeordnet ist, vor und nach dem Aktivieren des Dämpfungselements in einem Längsschnitt.

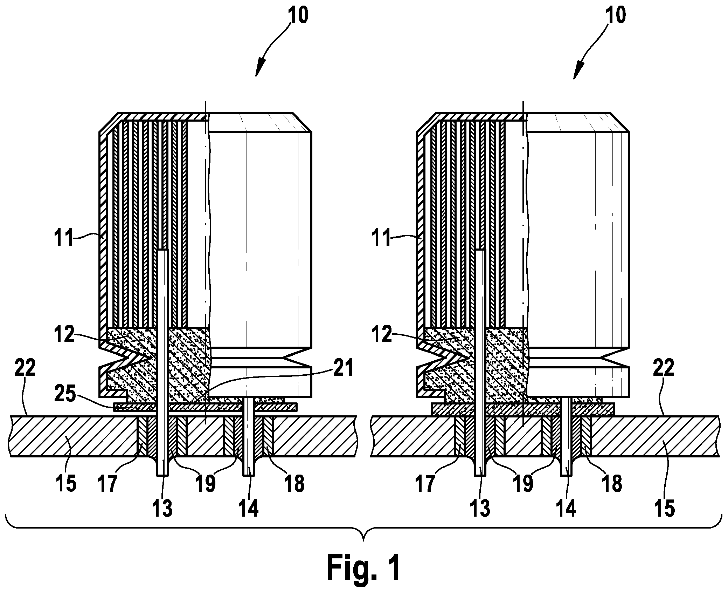

In der Fig. 1 ist ein Elektrolyt-Kondensator 10 (auch ELKO genannt) dargestellt, der ein topfförmiges Gehäuse 11 aufweist. An seinem offenen Ende ist das Gehäuse 11 von einem Verschlussstopfen 12 verschlossen. Aus dem Verschlussstopfen 12 ragen zwei in Bezug auf dessen Längsachse radial angeordnete elektrische Anschlüsse 13, 14 heraus, die mit einem als Leiterplatte 15 ausgebildeten Schaltungsträger elektrisch kontaktiert sind. Die Leiterplatte 15 ist insbesondere Bestandteil eines nicht dargestellten Steuergeräts, beispielsweise für den Einsatz in einem Kraftfahrzeug. Die Leiterplatte 15 weist für die beiden Anschlussdrähte 13, 14 Durchkontaktierungen 17, 18 auf, in der ein Lot 19 angeordnet ist, das die Anschlussdrähte 13, 14 mit den Durchkontaktierungen 17, 18 elektrisch leitend verbindet.

Zwischen der Unterseite 21 des Verschlussstopfens 12 und der Oberseite 22 der Leiterplatte 15 ist ein Abstand ausgebildet. Erfindungsgemäß ist vorgesehen, dass an der Unterseite 21 des Verschlussstopfens 12 ein plattenförmiges Dämpfungselement 25 angeordnet ist. Das Dämpfungselement 25 besteht aus einem Material, das sein Volumen unter dem Einfluss von Wärme und/oder chemischen Substanzen (beispielsweise eines chemischen Gases) ausdehnt. Ferner besteht das Dämpfungselement 25 aus einem elektrisch nicht leitenden Material. Insbesondere kann das Dämpfungselement 25 zum Beispiel aus einem PU-Schaum ausgebildet sein. Das Dämpfungselement 25 wird vor der Montage des Elektrolyt-Kondensators 10 an der Unterseite 21 des Elektrolyt-Kondensators 10 befestigt, beispielsweise mit der Unterseite 21 verklebt. Anschließend wird der Elektrolyt-Kondensator 10 entsprechend dem linken Teil der Fig. 1 mit der Leiterplatte 15 verbunden. Insbesondere durch den sich daran anschließenden Lötprozess wird Wärme über das Lot 19 bzw. die Leiterplatte 15 in den Bereich des Dämpfungselements 25 übertragen, wodurch dieses entsprechend dem rechten Teil der Fig. 1 sich ausdehnt und dabei den Zwischenraum zwischen der Oberseite 22 der Leiterplatte 15 und der Unterseite 21 des Verschlussstopfens 12 ausfüllt und einen Formschluss zwischen der Leiterplatte 15 und dem Elektrolyt-Kondensator 10 herstellt.

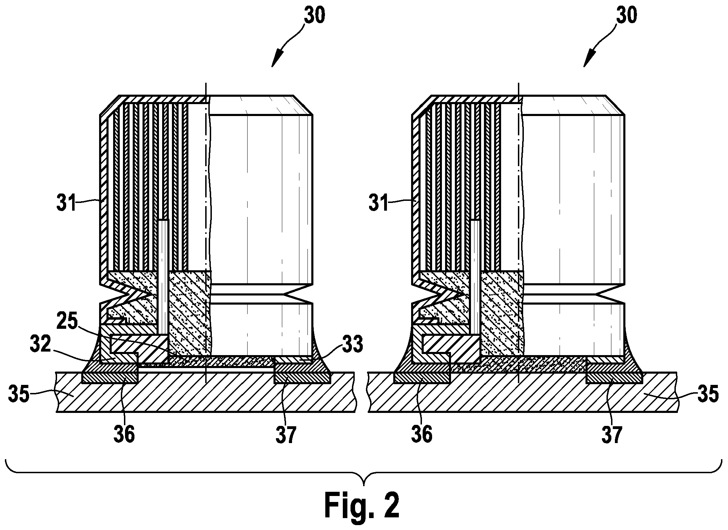

Der in der Fig. 2 dargestellte Elektrolyt-Kondensator 30 unterscheidet sich von dem Elektrolyt-Kondensator 10 gemäß der Fig. 1 dadurch, dass der Elektrolyt-Kondensator 30 in sogenannter SMD-Bauweise ausgebildet ist. Hierzu weist der Elektrolyt-Kondensator 30 zwei an der Unterseite seines Gehäuses 31 angeordnete Anschlussfahnen 32, 33 auf. Die Anschlussfahnen 32, 33 sind in Deckung mit auf der Leiterplatte 35 angeordneten Lands 36, 37 angeordnet, welche über Leiterbahnen mit der elektrischen Schaltung kontaktiert sind.

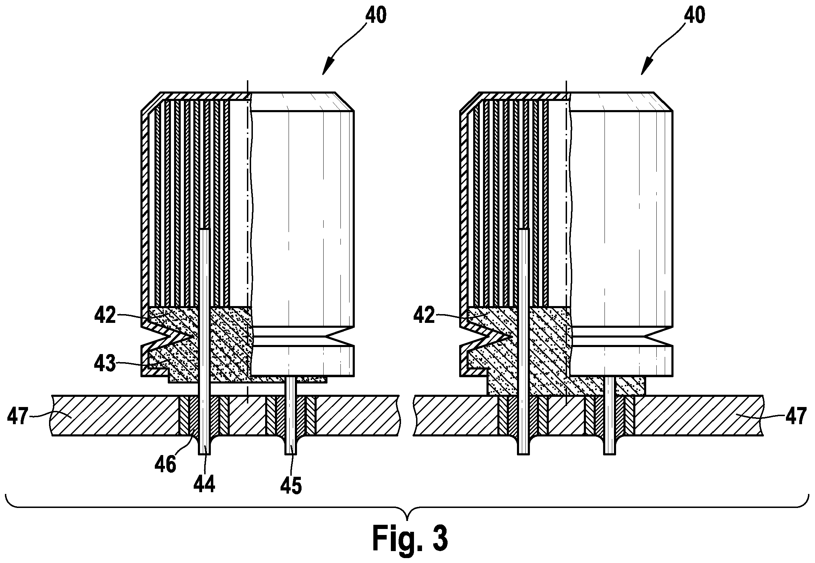

In der Fig. 3 ist ein weiterer Elektrolyt-Kondensator 40 dargestellt. Bei dem Elektrolyt-Kondensator 40 ist das Dämpfungselement 42 Bestandteil des Verschlussstopfens 43. Mit anderen Worten gesagt bedeutet dies, dass der Verschlussstopfen 43 aus einem Material besteht, welches sich unter dem Einfluss von Temperatur und/oder chemischen Substanzen ausdehnt. Ansonsten ist der Aufbau des Elektrolyt-Kondensators 40 ähnlich dem Elektrolyt-Kondensator 10.

Das bedeutet, dass der Elektrolyt-Kondensator 40 Anschlussdrähte 44, 45 aufweist, die aus der Unterseite des Elektrolyt-Kondensators 40 herausragen. Die Anschlussdrähte 44, 45 sind durch ein Lot 46 in der Leiterplatte 47 fest verankert.

Auch bei dem Elektrolyt-Kondensator 40 erfolgt die Aktivierung bzw. Volumenvergrößerung des Dämpfungselements 42 bevorzugt während des Lötprozesses. Hierbei dehnt sich der Verschlussstopfen 43 bis an die Oberseite der Leiterplatte 47 aus, so dass der Zwischenraum zwischen der Unterseite des Elektrolyt-Kondensators 40 und der Oberseite der Leiterplatte 47 formschlüssig ausgefüllt wird.

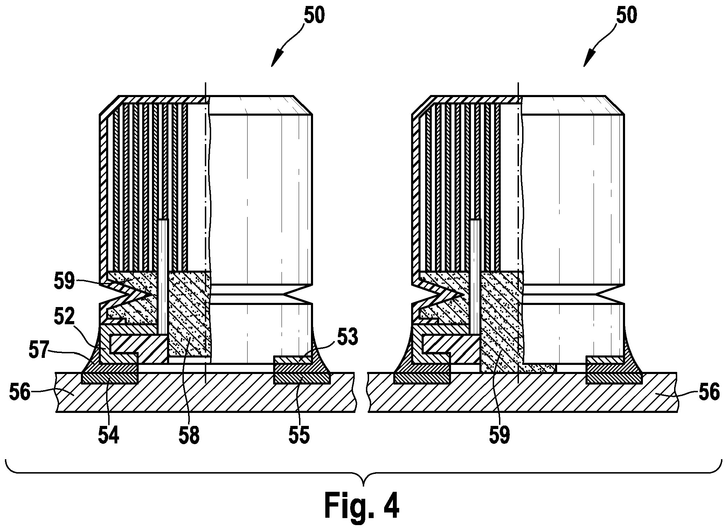

Der in der Fig. 4 dargestellte Elektrolyt-Kondensator 50 ist entsprechend dem Elektrolyt-Kondensator 30 ebenfalls in SMD-Bauweise ausgebildet. Das bedeutet, dass er Anschlussfahnen 52, 53 aufweist, die mit Lands 54, 55 auf der Leiterplatte 56 unter Zwischenlage eines Lots 57 verbunden sind. Entsprechend dem Elektrolyt-Kondensator 40 weist auch der Elektrolyt-Kondensator 50 einen Verschlussstopfen 58 auf, der gleichzeitig als Dämpfungselement 59 ausgebildet ist, d.h. aus einem Material besteht, welches durch Wärme und/oder chemische Substanzen sich im Volumen vergrößert.

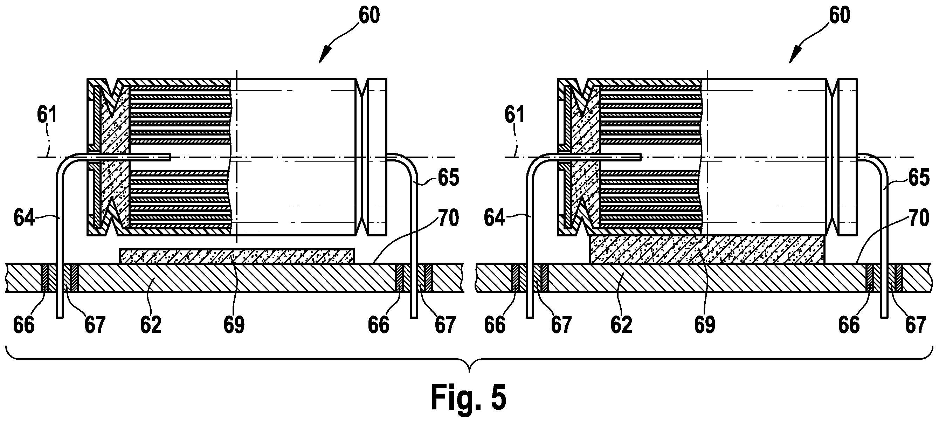

Zuletzt ist in der Fig. 5 ein weiterer Elektrolyt-Kondensator 60 dargestellt, welcher in so genannter axialer Bauform ausgebildet ist. Der Elektrolyt-Kondensator 60 weist eine Längsachse 61 auf, die parallel zur Leiterplatte 62 verläuft. Der in etwa zylindrisch ausgebildete Elektrolyt-Kondensator 60 weist an jeder seiner Stirnseiten in der Längsachse 61 einen Anschluss-Pin 64, 65 auf, welcher rechtwinklig umgebogen ist, um in eine Hülse 66 eingepasst zu werden, welche in der Leiterplatte 62 angeordnet ist. Ein Lot 67 verbindet hierbei die Anschlussdrähte 64, 65 mit der Hülse 66.

Bei dem Elektrolyt-Kondensator 60 ist ein Dämpfungselement 69 vorgesehen, welches an der Oberseite 70 der Leiterplatte 62 angeordnet ist bzw. mit der Leiterplatte 62 verbunden, z. B. verklebt, ist. Auch hier erfolgt die Aktivierung des Dämpfungselements 69 entweder durch die Einwirkung von Temperatur oder die Einwirkung einer chemischen Substanz, beispielsweise eines inerten Gases, so dass sich das Dämpfungselement 69 entsprechend dem rechten Teil der Fig. 5 ausdehnt und dabei den Zwischenraum zwischen der Oberseite 70 und dem Elektrolyt-Kondensator 60 vollständig überbrückt bzw. ausfüllt und sich formschlüssig an dem Elektrolyt-Kondensator 60 anschmiegt.

## Patentansprüche

1. Verfahren zur Herstellung einer Anordnung aus einem elektrischen oder elektronischen Bauteil (10; 40; 50; 60), einem Schaltungsträger (15; 35; 47; 56; 62) und einem Dämpfungselement (25; 42; 59; 69) für das Bauteil (10; 40; 50; 60), bei der das Bauteil (10; 40; 50; 60) über Anschlüsse (13, 14; 32, 33; 52, 53; 62, 65) mit dem Schaltungsträger (15; 35; 47; 56; 62), insbesondere mit einer Leiterplatte, elektrisch kontaktiert wird, wobei das Dämpfungselement (25; 42; 59; 69) in einem Zwischenraum zwischen dem Bauteil (10; 40; 50; 60) und dem Schaltungsträger (15; 35; 47; 56; 62) angeordnet wird, und wobei das Dämpfungselement (25; 42; 59; 69) als ein sich im Volumen unter dem Einfluss von Wärme und/oder chemischer Substanzen ausdehnbares Element ausgebildet ist,
**dadurch gekennzeichnet, dass**
vor einer Expansion des Dämpfungselements (25; 42; 59; 69) ein Zwischenraum zwischen dem Bauteil (10; 40; 50; 60) und dem Schaltungsträger (15; 35; 47; 56; 62) ausgebildet wird und danach durch den Einfluss von Wärme und/oder chemischen Substanzen eine Expansion des Dämpfungselements (25; 42; 59; 69) herbeigeführt wird und durch die Expansion das Dämpfungselement (25; 42; 59; 69) in Anlagekontakt sowohl mit dem Schaltungsträger (15; 35; 47; 56; 62) als auch mit dem Bauteil (10; 40; 50; 60) gelangt, wodurch der Zwischenraum zwischen dem Bauteil (10; 40; 50; 60) und dem Schaltungsträger (15; 35; 47; 56; 62) nach der Expansion ausgefüllt ist.

2. Verfahren nach Anspruch 1,
**dadurch gekennzeichnet,**
**dass** die Aktivierung des Dämpfungselements (25; 42; 59; 69) durch einen Lötprozess erfolgt.

3. Verfahren nach Anspruch 1 oder 2,
**dadurch gekennzeichnet, dass**
das Dämpfungselement (25; 69) als separates Element ausgebildet wird.

4. Verfahren nach Anspruch 3,
**dadurch gekennzeichnet, dass**
das Dämpfungselement (25) an dem Bauteil (10; 30) auf der dem Schaltungsträger (15; 35) zugewandten Seite befestigt wird.

5. Verfahren nach Anspruch 3,
**dadurch gekennzeichnet, dass**
das Dämpfungselement (69) auf dem Schaltungsträger (62) auf der dem Bauteil (60) zugewandten Seite angeordnet ist.

6. Verfahren nach einem der Ansprüche 1 bis 3,
**dadurch gekennzeichnet, dass**
das Dämpfungselement (42; 59) als ein im Bauteil (40; 50) integriertes Element ausgebildet wird, das auf der dem Schaltungsträger (47; 56) zugewandten Seite im Bauteil (40; 50) angeordnet wird.

7. Verfahren nach einem der vorhergehenden Ansprüche,
**dadurch gekennzeichnet, dass**
das Dämpfungselement (25; 42; 59; 69) aus einem elektrisch nicht leitenden Material besteht.

8. Verfahren nach einem der vorhergehenden Ansprüche,
**dadurch gekennzeichnet, dass**
das Material ein PU-Schaum ist.

9. Verfahren nach einem der vorhergehenden Ansprüche,
**dadurch gekennzeichnet, dass**
das Bauteil ein Elektrolyt-Kondensator (10; 40; 50; 60) ist.

## Claims

1. Method for producing an arrangement comprising an electrical or electronic component (10; 40; 50; 60), a circuit carrier (15; 35; 47; 56; 62) and a damping element (25; 42; 59; 69) for the component (10; 40; 50; 60), in which the component (10; 40; 50; 60) is electrically contact-connected to the circuit carrier (15; 35; 47; 56; 62), in particular to a printed circuit board, via connections (13, 14; 32, 33; 52, 53; 62, 65), wherein the damping element (25; 42; 59; 69) is arranged in an interspace between the component (10; 40; 50; 60) and the circuit carrier (15; 35; 47; 56; 62), and wherein the damping element (25; 42; 59; 69) is in the form of an element whose volume is expandable under the influence of heat and/or chemical substances, **characterized in that** an expansion of the damping element (25; 42; 59; 69) is preceded by an interspace being formed between the component (10; 40; 50; 60) and the circuit carrier (15; 35; 47; 56; 62), and this is followed by an expansion of the damping element (25; 42; 59; 69) being brought about by the influence of heat and/or chemical substances and, as a result of the expansion, the damping element (25; 42; 59; 69) coming into touching contact both with the circuit carrier (15; 35; 47; 56; 62) and with the component (10; 40; 50; 60), as a result of which the interspace between the component (10; 40; 50; 60) and the circuit carrier (15; 35; 47; 56; 52) is filled after the expansion.

2. Method according to Claim 1,
**characterized**
**in that** the damping element (25; 42; 59; 69) is activated by a soldering process.

3. Method according to Claim 1 or 2,
**characterized in that**
the damping element (25; 69) is produced as a separate element.

4. Method according to Claim 3,
**characterized in that**
the damping element (25) is mounted on the component (10; 30) on the side facing the circuit carrier (15; 35).

5. Method according to Claim 3,
**characterized in that**
the damping element (69) is arranged on the circuit carrier (62) on the side facing the component (60).

6. Method according to one of Claims 1 to 3,
**characterized in that**
the damping element (42; 59) is produced as an element that is integrated in the component (40; 50) and that is arranged in the component (40; 50) on the side facing the circuit carrier (47; 56).

7. Method according to one of the preceding claims,
**characterized in that**
the damping element (25; 42; 59; 69) consists of an electrically nonconductive material.

8. Method according to one of the preceding claims,
**characterized in that**
the material is a PU foam.

9. Method according to one of the preceding claims,
**characterized in that**
the component is an electrolytic capacitor (10; 40; 50; 60).

## Revendications

1. Procédé de fabrication d'un arrangement constitué d'un composant (10 ; 40 ; 50 ; 60) électrique ou électronique, d'un porte-circuit (15 ; 35 ; 47 ; 56 ; 62) et d'un élément d'amortissement (25 ; 42 ; 59 ; 69) pour le composant (10 ; 40 ; 50 ; 60), avec lequel le composant (10 ; 40 ; 50 ; 60) est mis en contact électrique avec le porte-circuit (15 ; 35 ; 47 ; 56 ; 62), notamment avec un circuit imprimé, par le biais de bornes (13, 14 ; 32, 33 ; 52, 53 ; 62, 65), l'élément d'amortissement (25 ; 42 ; 59 ; 69) étant disposé dans un espace intermédiaire entre le composant (10 ; 40 ; 50 ; 60) et le porte-circuit (15 ; 35 ; 47 ; 56 ; 62), et l'élément d'amortissement (25 ; 42 ; 59 ; 69) étant réalisé sous la forme d'un élément expansible en volume sous l'influence de la chaleur et/ou de substances chimiques,
**caractérisé en ce que**
avant une expansion de l'élément d'amortissement (25 ; 42 ; 59 ; 69), un espace intermédiaire est formé entre le composant (10 ; 40 ; 50 ; 60) et le porte-circuit (15 ; 35 ; 47 ; 56 ; 62) et ensuite une expansion de l'élément d'amortissement (25 ; 42 ; 59 ; 69) est produite par l'influence de la chaleur et/ou de substances chimiques et, par l'expansion, l'élément d'amortissement (25 ; 42 ; 59 ; 69) entre en contact d'appui à la fois avec le porte-circuit (15 ; 35 ; 47 ; 56 ; 62) et avec le composant (10 ; 40 ; 50 ; 60), moyennant quoi l'espace intermédiaire entre le composant (10 ; 40 ; 50 ; 60) et le porte-circuit (15 ; 35 ; 47 ; 56 ; 62) est rempli après l'expansion.

2. Procédé selon la revendication 1,
**caractérisé en ce que**
l'activation de l'élément d'amortissement (25 ; 42 ; 59 ; 69) s'effectue par un processus de brasage.

3. Procédé selon la revendication 1 ou 2,
**caractérisé en ce que**
l'élément d'amortissement (25 ; 69) est réalisé sous la forme d'un élément séparé.

4. Procédé selon la revendication 3,
**caractérisé en ce que**
l'élément d'amortissement (25) est fixé au composant (10 ; 30) sur le côté qui fait face au porte-circuit (15 ; 35).

5. Procédé selon la revendication 3,
**caractérisé en ce que**
l'élément d'amortissement (69) est disposé sur le porte-circuit (62) sur le côté qui fait face au composant (60).

6. Procédé selon l'une des revendications 1 à 3,
**caractérisé en ce que**
l'élément d'amortissement (42 ; 59) est réalisé sous la forme d'un élément intégré dans le composant (40 ; 50), qui est disposé dans le composant (40 ; 50) sur le côté qui fait face au porte-circuit (47 ; 56).

7. Procédé selon l'une des revendications précédentes,
**caractérisé en ce que**
l'élément d'amortissement (25 ; 42 ; 59 ; 69) se compose d'un matériau électriquement non conducteur.

8. Procédé selon l'une des revendications précédentes,
**caractérisé en ce que**
le matériau est une mousse de PU.

9. Procédé selon l'une des revendications précédentes,
**caractérisé en ce que**
le composant est un condensateur électrolytique (10 ; 40 ; 50 ; 60).
